# EUROPEAN PATENT APPLICATION

(11) **EP 4 827 297 A1**
(43) Date of publication of application: **21.10.2026**
(21) Application number: 25210786.7
(22) Date of filing: 23.10.2025
(51) Int. Cl.: H10K 59/65, H10K 71/00, H10K 10/00

(54) **METHOD OF MANUFACTURING DISPLAY DEVICE AND ELECTRONIC DEVICE MANUFACTURED USING THE METHOD**

(30) Priority: 18.04.2025 KR 20250050609
(71) Applicant: Samsung Display Co., Ltd., Yongin-City, Gyeonggi-Do, 446-711 (KR)
(72) Inventor: Jeun, Jin Hong, 17113 Yongin-si, Gyeonggi-do (KR); Seo, Minkyo, 17113 Yongin-si, Gyeonggi-do (KR); Woo, Jeonghun, 17113 Yongin-si, Gyeonggi-do (KR); Lee, Doo-Won, 17113 Yongin-si, Gyeonggi-do (KR); Lee, Haesook, 17113 Yongin-si, Gyeonggi-do (KR); Roh, Cheollae, 17113 Yongin-si, Gyeonggi-do (KR); Ryu, Jekil, 17113 Yongin-si, Gyeonggi-do (KR); Lee, Seungjoo, 17113 Yongin-si, Gyeonggi-do (KR); Park, Sung-Dong, 17113 Yongin-si, Gyeonggi-do (KR); Lee, Kwangmin, 17113 Yongin-si, Gyeonggi-do (KR)
(74) Representative: Gulde & Partner

(57) **Abstract**

A method of manufacturing a display device including a module hole from a preliminary display panel including a substrate, and a thin-film transistor layer, a display element layer, and an encapsulation layer which are sequentially stacked on the substrate, includes providing the preliminary display panel including a machining surface on a surface thereof and having a hole machining area corresponding to the module hole defined in the machining surface, a first machining operation of irradiating a first laser beam along the hole machining area, a second machining operation of irradiating a second laser beam to a dummy area with the hole machining area as a boundary to separate the dummy area from the preliminary display panel, and a third machining operation of irradiating a third laser beam onto an edge of the module hole from which the dummy area is separated, to machine the edge of the module hole.

## Description

### BACKGROUND

### 1. Field

The disclosure relates to a method of manufacturing a display device including a module hole.

### 2. Description of the Related Art

Display devices may display an image by including a light-emitting element. The display devices are applied to various electronic devices such as smartphones, digital cameras, laptop computers, navigation systems, televisions, etc., and are being developed in various forms. The display device may include at least one module hole formed corresponding to positions where optical devices such as cameras, sensors, etc., and other various modules are arranged, and various technologies are being developed to form such module holes.

### SUMMARY

The disclosure provides a method of manufacturing a display device including a method of forming a module hole in a dry cutting manner using a laser beam.

According to an aspect of the disclosure, a method of manufacturing a display device including a module hole from a preliminary display panel including at least a substrate, and a thin-film transistor layer, a display element layer, and an encapsulation layer, which are sequentially stacked on the substrate, includes providing the preliminary display panel including a machining surface on a surface thereof and having a hole machining area corresponding to the module hole defined in the machining surface, a first machining operation of irradiating a first laser beam along the hole machining area, a second machining operation of irradiating a second laser beam to a dummy area with the hole machining area as a boundary to separate the dummy area from the preliminary display panel, and a third machining operation of irradiating a third laser beam onto an edge of the module hole from which the dummy area is separated, to machine the edge of the module hole.

A type of the first laser beam may be an infrared (IR) laser beam, a type of the second laser beam may be a carbon dioxide laser beam, and a type of the third laser beam may be an ultraviolet (UV) laser beam.

A shape of the first laser beam may be a Bessel beam, a shape of the second laser beam may be a flat top Gaussian beam or super Gaussian beam having a uniform intensity distribution from a center of the second laser beam to opposite edges of the second laser beam, and a shape of the third laser beam may be a Gaussian beam.

A wavelength range of the first laser beam may be less than a wavelength range of the second laser beam and may be greater than a wavelength range of the third laser beam.

The first laser beam may be a Bessel beam, and a length of a region corresponding to 85% or more of a maximum intensity of the first laser beam may be 65% or more of a thickness of the preliminary display panel.

The second laser beam may be fixedly irradiated to a position in the dummy area.

A beam spot size of the second laser beam may be in a range of about 0.25 to about 0.6 times the size of the hole machining area.

The second laser beam may be irradiated for a time in a range of about 100 milliseconds to about 1000 milliseconds.

The second laser beam may be irradiated while moving a position thereof in the dummy area.

The second laser beam may be irradiated while repeatedly moving along a scan path positioned in the dummy area.

The hole machining area may have a circular shape, the scan path may have a circular shape, and a diameter of the scan path may be 0.85 times or less a diameter of the hole machining area.

The edge of the module hole may include an upper edge where an inner surface of the module hole and the machining surface meet each other, and a lower edge where the inner surface of the module hole and an opposite surface facing the machining surface meet each other, and the third laser beam may machine at least one of the upper edge or the lower edge such that the at least one of the upper edge or the lower edge has a slope or a curvature surface.

The third laser beam may simultaneously machine the upper edge and the lower edge.

The third laser beam may machine one of the upper edge or the lower edge first and then sequentially machines the other.

The third laser beam may repeatedly machine the edge of the module hole to adjust the shape of the slope or the shape of the curvature surface of at least one of the upper edge or the lower edge.

According to another aspect of the disclosure, a method of manufacturing a display device including a module hole includes forming at least one display cell on a first surface of a mother substrate, the at least one display cell including a machining surface and having a hole machining area defined on the machining surface, reducing a thickness of the substrate by spraying an etchant onto a second surface facing the first surface of the substrate, a first machining operation of irradiating a first laser beam onto the first surface along the hole machining area and irradiating the first laser beam along a cell machining area for cutting the display cell, a second machining operation of separating a dummy area from the display cell by irradiating a second laser beam to the dummy area on the first surface with the hole machining area as a boundary, and separating the display cell from the mother substrate by irradiating the second laser beam onto the cell machining area, and a third machining operation of irradiating the third laser beam onto an edge of the module hole from which the dummy area is separated, to machine the edge of the module hole.

The third machining operation may further include machining a side edge of the separated display cell by irradiating the third laser beam onto the side edge of the separated display cell.

A type of the first laser beam may be an infrared (IR) laser beam, a type of the second laser beam may be a carbon dioxide laser beam, and a type of the third laser beam may be an ultraviolet (UV) laser beam.

A shape of the first laser beam may be a Bessel beam, a shape of the second laser beam may be a flat top Gaussian beam having a uniform intensity distribution from a center of the second laser beam to an edge of the second laser beam, and a shape of the third laser beam may be a Gaussian beam.

A wavelength range of the first laser beam may be less than a wavelength range of the second laser beam and may be greater than a wavelength range of the third laser beam.

According to another aspect of the disclosure, an electronic apparatus includes a display device including a display panel including at least a substrate, and a thin-film transistor layer, a display element layer, and an encapsulation layer, which are sequentially stacked on the substrate, and a module hole provided in the display panel, a controller configured to generate a control signal for driving a pixel circuit included in the thin-film transistor layer, and a power module configured to apply power to the controller, in which the display device is manufactured using a method including providing the preliminary display panel including a machining surface on a surface thereof and having a hole machining area corresponding to the module hole defined in the machining surface, a first machining operation of irradiating a first laser beam along the hole machining area, a second machining operation of irradiating a second laser beam to a dummy area with the hole machining area as a boundary to separate the dummy area from the preliminary display panel, and a third machining operation of irradiating the third laser beam onto an edge of the module hole from which the dummy area is separated, to machine the edge of the module hole.

### BRIEF DESCRIPTION OF THE DRAWINGS

The above and other aspects, features, and advantages of certain embodiments of the disclosure will be more apparent from the following description taken in conjunction with the accompanying drawings in which:
FIG. 1 is a schematic plan view of an electronic device according to an embodiment;
FIG. 2 is a perspective view showing a display device included in an electronic device according to an embodiment;
FIG. 3 is a cross-sectional view of the display device of FIG. 2 viewed from a side;
FIG. 4 is a flowchart of a method of manufacturing a display device according to an embodiment;
FIG. 5 is a view for describing an operation of forming a module hole of FIG. 4;
FIG. 6 is a view for describing in detail operation 102 of FIG. 4;
FIGS. 7A to 7C are a view for describing various examples in which a second laser beam is irradiated to a dummy area in operation 102;
FIGS. 8A and 8B show pictures of an edge of a module hole machined in operation 103;
FIGS. 9A and 9B are a view for describing various examples in which an edge of a module hole is machined using a third laser beam in operation 103;
FIG. 10 is a view showing a method of machining an edge of a module hole using a third laser beam according to another embodiment;
FIG. 11 is a flowchart of a method of manufacturing a display device according to another embodiment;
FIG. 12 is a view for describing operations 200a and 200b of FIG. 11;
FIG. 13 is a view for describing operation 200c of FIG. 11;
FIG. 14 is a view for describing operation 201 of FIG. 11;
FIG. 15 is a view for describing operation 202 of FIG. 11;
FIG. 16 is a view for describing operation 202 of FIG. 11;
FIG. 17 is a view for describing operation 203 of FIG. 11;
FIG. 18 is a block diagram of an electronic device according to an embodiment; and
FIG. 19 show schematic diagrams of an electronic device according to various embodiments.

### DETAILED DESCRIPTION

The disclosure may have various modifications thereto and various embodiments, and thus particular embodiments will be illustrated in the drawings and described in detail in a detailed description. Effects and features of the disclosure, and methods for achieving them will become clear with reference to the embodiments described later in detail together with the drawings. However, the disclosure is not limited to the embodiments disclosed below and may be implemented in various forms.

In the following embodiments, the terms such as first, second, etc., have been used to distinguish one component from other components, rather than limiting.

In the following embodiments, singular forms include plural forms unless apparently indicated otherwise contextually.

In the following embodiments, the terms "include", "have", or the like, are intended to mean that there are features, or components, described herein, but do not preclude the possibility of adding one or more other features or components.

In the following embodiments, when a portion, such as a unit, a region, a component, etc., is present on or above another portion, this case may include not only a case where it is directly on the other portion, but also a case where another unit, region, component, etc., is arranged between the portion and the other portion.

In the following embodiments, terms such as connect or combine do not necessarily imply a direct and/or fixed connection or combination of two members, unless the context clearly indicates otherwise, and do not exclude the presence of another member between the two members.

In the drawings, the size of components may be exaggerated or reduced for convenience of description. For example, the size and/or thickness of each component shown in the drawing are arbitrarily shown for convenience of explanation.

In the following embodiments, when various components such as layers, films, regions, plates, etc., are "on" other components, this may include not only a case where they are "right on" the other components, but also a case where other components are interposed between them. In the drawings, the size of components may be exaggerated or reduced for convenience of description. For example, the size and thickness of each component shown in the drawing are arbitrarily shown for convenience of explanation.

In the following embodiments, an X-axis, a Y-axis, and a Z-axis are not limited to three axes on an orthogonal coordinate system, and may be interpreted in a broad sense including them. For example, the X-axis, Y-axis, and Z-axis may be orthogonal to each other, but they can also refer to different directions that are not orthogonal to each other.

In the following embodiments, in case that "about" is used in connection with a numerical value, it is intended to include a tolerance of ±10% around the numerical value.

Hereinafter, embodiments of the disclosure will be described in detail with reference to the attached drawings, and in the description with reference to the drawings, identical or corresponding components are given the same reference numerals and redundant descriptions thereof will be omitted.

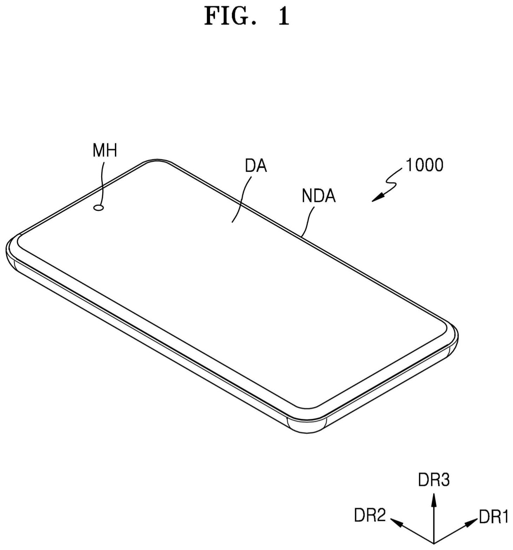

FIG. 1 is a schematic plan view of an electronic device according to an embodiment.

Referring to FIG. 1, an electronic device 1000 may refer to any electronic device that provides a display screen. For example, a television, a laptop computer, a monitor, a billboard, an Internet of Things (IoT), a mobile phone, a smartphone, a tablet personal computer (PC), an electronic watch, a smart watch, a watch phone, a head-mounted display, a mobile communication terminal, an electronic notebook, an electronic book, a portable multimedia player (PMP), a navigation system, a game console, a digital camera, a camcorder, etc., which provides a display screen, may be included in the electronic device 1000. Hereinbelow, a smartphone will be used as an example of the electronic device 1000. However, the example is not limited thereto and the advantages associated with the example also translate to different types of electronic device 1000 that provide a display screen.

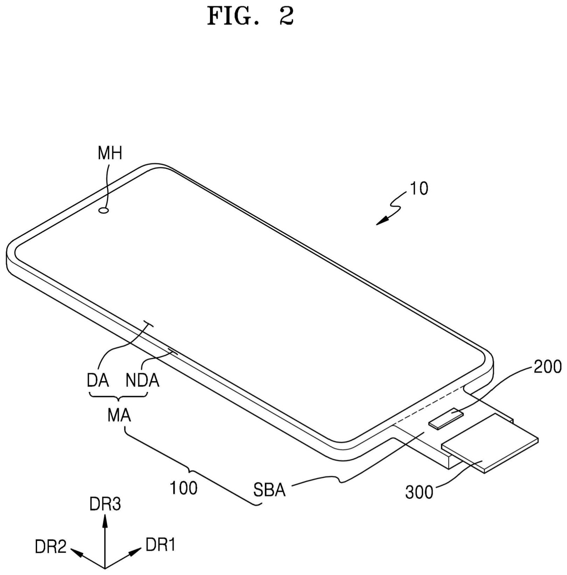

The electronic device 1000 may include a display device 10 of FIG. 2 providing the display screen as one module. Examples of the display device may include inorganic light-emitting diode display devices, organic light-emitting display devices, quantum dot light-emitting display devices, plasma display devices, field emission display devices, etc. Hereinbelow, an organic light-emitting diode is used as an example of a display device, but the disclosure is not limited thereto, and other display devices may be used as long as the same technical idea is applicable thereto.

The shape of the electronic device 1000 may be modified in various ways. For example, the electronic device 1000 may have a shape such as a long-width rectangle, a long-length rectangle, a square, a rectangle with rounded corners (vertices), other polygons, a circle, etc. The shape of a display area DA of the electronic device 1000 may also be similar to the overall shape of the electronic device 1000. In FIG. 1, the electronic device 1000 having a long-length rectangular shape in a second direction DR2 is shown.

The electronic device 1000 may include the display area DA and a non-display area NDA. The display area DA may be an area where a screen may be displayed, and the non-display area NDA may be an area where a screen is not displayed. The display area DA may also be referred to as an active area, and the non-display area NDA may also be referred to as an inactive area. The display area DA may generally occupy the center of the electronic device 1000. A center of the electronic device 1000 may be defined by an area with a distance more than 1 mm to its frame.

A module hole MH may be arranged in a side of the display area DA. The module hole MH may transmit light and correspond to a region where an optical device is arranged.

FIG. 2 is a perspective view showing a display device included in an electronic device according to an embodiment.

Referring to FIG. 2, the electronic device 1000 according to an embodiment may include the display device 10. The display device 10 may provide a screen to be displayed on the electronic device 1000. The display device 10 may have a flat shape similar to the electronic device 1000. For example, the display device 10 may have a shape similar to a rectangle having a short side in a first direction DR1 and a long side in the second direction DR2. A corner where the short side in the first direction DR1 and the long side in the second direction DR2 meet may be formed roundly to have a curvature, but the disclosure is not limited thereto and the corner may also be formed at a right angle. The flat shape of the display device 10 is not limited to a quadrangle, and may be formed similarly to other polygons, circles, or ovals.

The display device 10 may include a display panel 100, a driving integrated circuit (IC) 200, and a circuit board 300.

The display panel 100 may include a main area MA and a sub-area SBA.

The main area MA may include the display area DA including pixels presenting an image, and the non-display area NDA arranged around the display area DA. The display area DA may emit light from a plurality of light-emitting areas or a plurality of opening areas. For example, the display panel 100 may include a pixel circuit including switching elements, a pixel-defining film defining a light-emitting area or an opening area, and a self-light-emitting element.

For example, the self-light-emitting element may include, but not limited to, at least one of an organic light-emitting diode (OLED) including an organic light-emitting layer, a quantum dot LED including a quantum dot light-emitting layer, an inorganic LED including an inorganic semiconductor, and a micro light-emitting diode (micro LED).

The non-display area NDA may be outside the display area DA. The non-display area NDA may be defined as an edge area of the main area MA of the display panel 100. The non-display area NDA may include a scan driver (not shown) that supplies scan signals to scan lines, and fan out lines (not shown) that connect the driving IC 200 to the display area DA.

A sub-area SBA may be an area extending from a side of the main area MA. The sub-area SBA may include a flexible material capable of bending, folding, rolling, etc. For example, when the sub-area SBA is bent, the sub-area SBA may overlap the main area MA in a thickness direction (a third direction DR3). The sub-area SBA may include the driving IC 200 and a pad portion connected to the circuit board 300. In another embodiment, the sub-area SBA may be omitted, and the driving IC 200 and the pad portion may be arranged in the non-display area NDA.

The driving IC 200 may output signals and voltages for driving the display panel 100. The driving IC 200 may supply data voltages to data lines. For example, the driving IC 200 may include a data driver that may supply data voltages to data lines. The driving IC 200 may supply a power voltage to a power line and supply a scan control signal to a scan driver. The driving IC 200 may be formed as an integrated circuit (IC) and may be mounted on the display panel 100 in a chip on glass (COG) manner, a chip on plastic (COP) manner, or an ultrasonic bonding manner. For example, the driving IC 200 may be arranged in the sub-area SBA and may overlap the main area MA in a thickness direction by bending the sub-area SBA. In another example, the driving IC 200 may be mounted on the circuit board 300.

The circuit board 300 may be attached to the pad portion of the display panel 100 using an anisotropic conductive film (ACF). Lead lines of the circuit board 300 may be electrically connected to the pad portion of the display panel 100. The circuit board 300 may be a flexible printed circuit board, a printed circuit board, or a flexible film such as a chip on film.

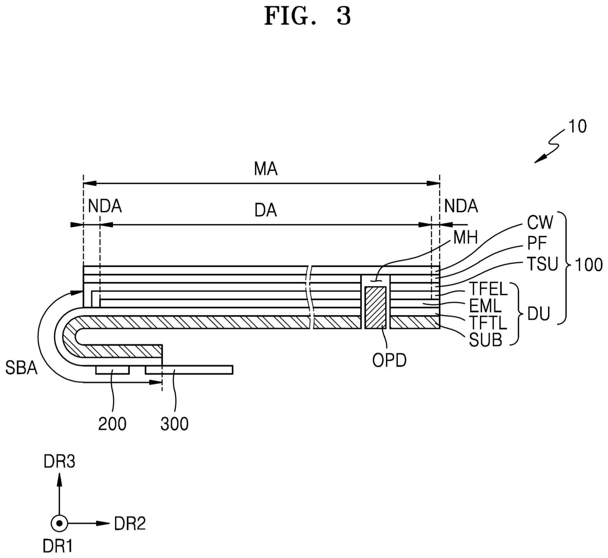

FIG. 3 is a cross-sectional view of the display device of FIG. 2 viewed from a side.

Referring to FIG. 3, the display device 10 may include the display panel 100, a touch sensing layer TSU, a polarizing film PF, and a cover window CW in the third direction DR3. The display panel 100 may include at least a substrate SUB, a thin-film transistor layer TFTL, a light-emitting element layer EML, and an encapsulation layer TFEL, in the third direction DR3. The thickness of the display panel 100 may be about 200 micrometers (µm) or less.

The substrate SUB may be a base substrate or a base member. For example, the substrate SUB may include, but is not limited to, a glass material. In another embodiment, the substrate SUB may include a polymer resin such as polyimide (PI) or a metal material. Hereinbelow, an example will be given in which the substrate SUB is formed of a glass material.

The substrate SUB may have a thickness in a range of about 20 µm to about 50 micrometers to manufacture the ultra-thin (UT) display panel 100. The thickness of the substrate SUB may be about 30 µm. The substrate SUB may have a thickness reduced by etching a mother substrate MSUB having a thickness exceeding about 50 µm.

The thin-film transistor layer TFTL may be arranged on the substrate SUB. The thin-film transistor layer TFTL may include a plurality of thin-film transistors that constitute a pixel circuitry of pixels. The thin-film transistor layer TFTL may further include scan lines, data lines, power lines, scan control lines, fan out lines connecting the driving IC 200 to the data lines, and lead lines connecting the driving IC 200 to the pad portion. Each of thin-film transistors may include a semiconductor region, a source electrode, a drain electrode, and a gate electrode.

The thin-film transistor layer TFTL may be arranged in the display area DA, the non-display area NDA, and the sub-area SBA. Thin-film transistors, scan lines, data lines, and power lines of respective pixels of the thin-film transistor layer TFTL may be arranged in the display area DA. Scan control lines and fan out lines of the thin-film transistor layer TFTL may be arranged in the non-display area NDA. Lead lines of the thin-film transistor layer TFTL may be arranged in the sub-area SBA.

The light-emitting element layer EML may be arranged on the thin-film transistor layer TFTL. The light-emitting element layer EML may include a plurality of light-emitting elements that emit light, including a pixel electrode, a common electrode, and a light-emitting layer, and a pixel-defining film that defines light-emitting regions. The plurality of light-emitting elements of the light-emitting element layer EML may be arranged in the display area DA.

In an embodiment, the light-emitting layer may be an organic light-emitting layer including an organic material. The light-emitting layer may include a hole transporting layer, an organic light-emitting layer, and an electron transporting layer. In case that the pixel electrode receives a voltage through the thin-film transistor of the thin-film transistor layer TFTL and the common electrode receives a cathode voltage, holes and electrons may move to the organic light-emitting layer through the hole transport layer and the electron transport layer, respectively, and emit light in combination with each other in the organic light-emitting layer.

In other embodiments, the light-emitting element may include a quantum dot light-emitting diode including a quantum dot light-emitting layer, an inorganic light-emitting diode including an inorganic semiconductor, or a micro light-emitting diode.

The touch sensing layer TSU may be arranged on the encapsulation layer TFEL. The touch sensing layer TSU may include a plurality of touch electrodes for detecting a user's touch in a capacitive manner, and touch lines connecting the plurality of touch electrodes to a touch driving unit (not shown). For example, the touch sensing layer TSU may sense the user's touch in a mutual capacitance or self-capacitance manner.

The polarizing film PF may be placed on the touch sensing layer TSU. The polarizing film PF may be arranged on the display panel 100 to reduce external light reflection. The polarizing film PF may include a first base member, a linear polarizing plate, a phase retardation film such as a Λ/4 plate (quarter-wave plate), and a second base member. The first base member, the phase retardation film, the linear polarizing plate, and the second base member of the polarizing film PF may be sequentially stacked on the touch sensing layer TSU.

The cover window CW may be arranged on the polarizing film PF. The cover window CW may be attached to the polarizing film PF by a transparent adhesive material such as an optically clear adhesive (OCA) film.

According to another embodiment, a color filter layer (not shown), instead of the polarizing film PF and the cover window CW, may be arranged on the touch sensing layer TSU. The color filter layer may include a plurality of color filters respectively corresponding to a plurality of light-emitting regions. Each color filter may selectively transmit light of a specific wavelength and block or absorb light of other wavelengths. The color filter layer may absorb a part of the light coming from the outside of the display device 10 to reduce reflected light due to external light. Thus, the color filter layer advantageously prevents color distortion due to external light reflection.

As the color filter layer is arranged directly on the touch sensing layer TSU, the display device 10 may not require a separate substrate for the color filter layer. Thus, the thickness of the display device 10 may be relatively small.

The module hole MH may be arranged in the display panel 100. The module hole MH may be a hole which allows light to pass therethrough. The module hole MH may pass through the display panel 100 at least including the thin-film transistor layer TFTL, the light-emitting element layer EML, and the encapsulation layer TFEL. The module hole MH may be a physical hole which passes through not only the display panel 100, but also at least one of the touch sensing layer TSU, the polarizing film PF, or the color filter layer (not shown). However, the disclosure is not limited thereto, and the module hole MH may not pass through at least one of the touch sensing layer TSU, the polarizing film PF, or the color filter layer. The cover window CW may be positioned to cover the module hole MH.

The display device 10 may further include an optical device OPD arranged in the module hole MH. The optical device OPD may be spaced apart from a display layer DU. The optical device OPD may be an optical sensor that detects light incident through the module hole MH, such as a proximity sensor, an illuminance sensor, and a camera sensor.

A module hole is generally formed through a chemical etching process or a mechanical drilling process. However, for the chemical etching process, an etchant may penetrate into the display panel 100 when the module hole is formed, and to prevent the penetration, a separate process of attaching an acid-resistant film needs to be added, which increases the complexity and cost of the process. Etching uniformity variation occurs in the chemical etching process, in which the depth, area, and shape etched are not uniform depending on process conditions, resulting in an end tip and chipping at the edge of the module hole. A crack may occur in the thin-film transistor layer TFTL and the encapsulation layer TFEL around the module hole during the drilling and grinding process.

According to embodiments of the disclosure, a method of manufacturing the display device 10 is provided, including a method of forming the module hole MH in the display panel 100 by a dry cutting method using a laser beam without using the chemical etching process or the mechanical drilling process.

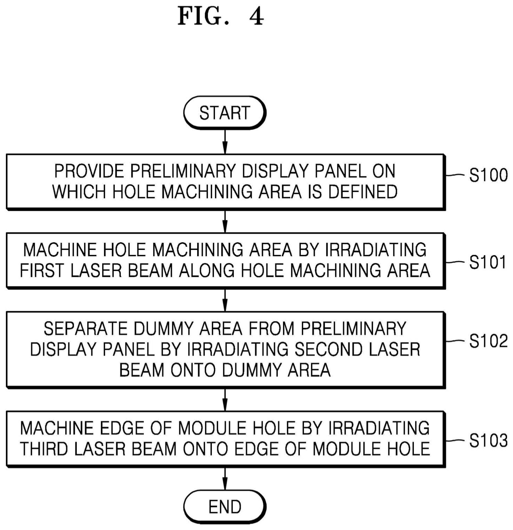

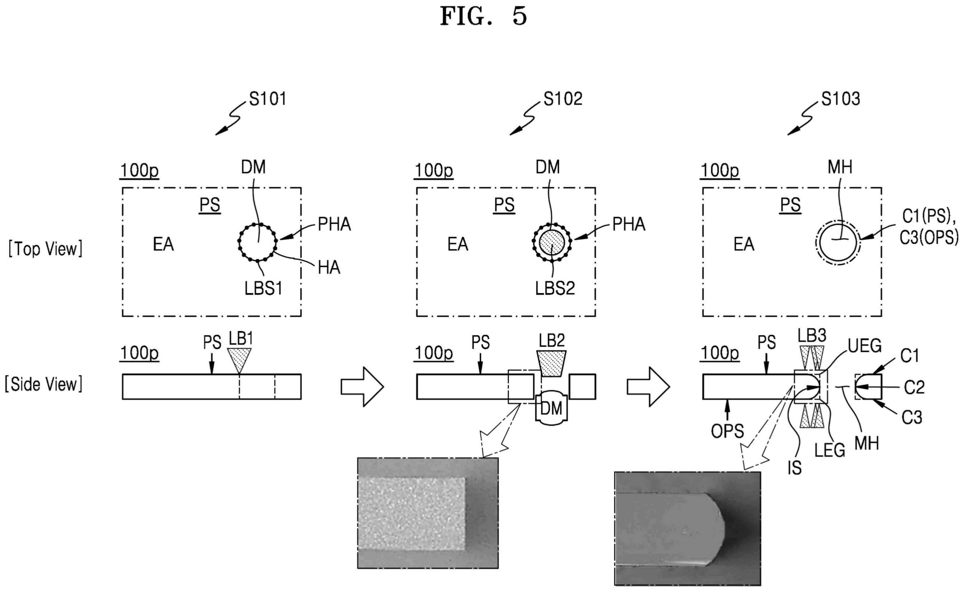

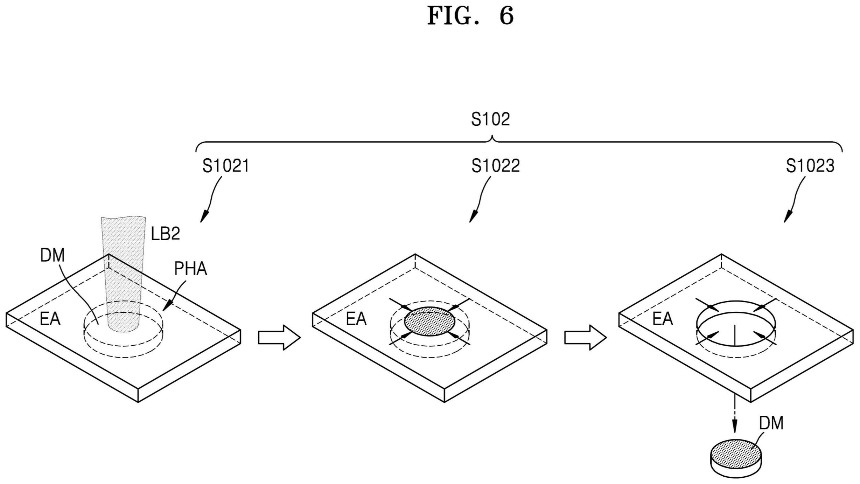

FIG. 4 is a flowchart of a method of manufacturing a display device according to an embodiment. FIG. 5 is a view for describing an operation of forming a module hole of FIG. 4. FIG. 6 is a view for describing in detail operation 102 of FIG. 4.

Referring to FIG. 4, a method of manufacturing the display device 10 according to one embodiment may include operation S100 of providing a preliminary display panel 100p including, on a surface thereof, a machining surface PS in which a hole machining area HA corresponding to the module hole MH is defined, a first machining operation S101 of irradiating a first laser beam LB1 along the hole machining area HA, a second machining operation S102 of irradiating a second laser beam LB2 to a dummy area DM not included in a final product using the hole machining area HA as a boundary to separate the dummy area DM from the preliminary display panel 100p, and a third machining operation S103 of irradiating a third laser beam LB3 to an edge of the module hole MH from which the dummy area DM is separated to machine the edge of the module hole MH. A manufacturing process of the display device 10 of FIG. 4 may be performed by a manufacturing system (not shown) of the display device 10, and the manufacturing system of the display device 10 may include at least a first laser device (an infrared (IR) laser device), a second laser device (a carbon dioxide laser device), and a third laser device (an ultraviolet (UV) laser device).

The preliminary display panel 100p may be defined as a state before at least the module hole MH is formed in the display panel 100 described in FIG. 3. The preliminary display panel 100p may include at least the substrate SUB, the thin-film transistor layer TFTL formed on the substrate SUB, the light-emitting element layer EML formed on the thin-film transistor layer TFTL, and the encapsulation layer TFEL formed on the light-emitting element layer EML. The thickness of the preliminary display panel 100p may be about 200 µm or less, and preferably in a range of more than about 50 µm to about 200 µm or less.

The preliminary display panel 100p may include the machining surface PS on a surface thereof on which a laser beam is to be irradiated. The machining surface PS may include an effective area EA included in the display panel which is a final product, the dummy area DM not included in the display panel 100 which is the final product, and the hole machining area HA corresponding to a boundary between the effective area EA and the dummy area DM.

The effective area EA may be the display area DA or a part thereof where the screen is displayed, or a part of the non-display area NDA which is included in the final product even in case that the screen is not displayed therein.

The dummy area DM may be a part removed by laser machining and may correspond to the module hole MH of the display panel 100 after laser machining.

The hole machining area HA may be a machining position where the module hole MH is to be formed, and may be a part to which the first laser beam LB1 is to be irradiated to remove the dummy area DM. The hole machining area HA may have the same shape as the module hole MH.

The hole machining area HA may have a closed curve shape on the machining surface PS. The hole machining area HA may have circular, triangular, quadrangular, or other polygonal shapes. The following description will be made using an example where the hole machining area HA has the circular shape and has a diameter of about 2 millimeters (Mm) to about 4 Mm.

Referring to FIGS. 4 and 5, in operation 101, the first laser beam LB1 may be irradiated along the hole machining area HA to form a hole machining pattern PHA including cracks formed along the thickness of the preliminary display panel 100p corresponding to the hole machining area HA. As the hole machining pattern PHA corresponds to the hole machining area HA, the dummy area DM may be partially separated from the effective area EA by a crack, but may still be connected to the effective area EA.

The first laser beam LB1 may be an IR laser beam generated by an infrared laser device, and may form filamentation which is a line of fine grooves along the thickness of the preliminary display panel 100p in a laser irradiation area in the shape of a Bessel beam. As the Bessel beam deforms a microscopic structure of a cross-section of a workpiece, filamentation, which is a line or film of microscopic grooves along the thickness of the workpiece, may be observed.

The hole machining pattern PHA may be a set of machining points to which the first laser beam LB1 is irradiated, corresponding to the hole machining area HA. The filamentation shown in the cross-section of the drawing may be an example of one machining point on the cross-section of the preliminary display panel 100p. A first beam spot LBS1 shown in the plan view of the drawing may be an example of one machining point on the plane of the preliminary display panel 100p. The first beam spot LBS1 may be arranged at regular intervals along the hole machining area HA.

A wavelength of the first laser beam LB1 may be in a range of about 0.5 µm to about 2.5 µm, and preferably in a range of about 1.0 µm to about 2.0 µm. In case that the wavelength of the first laser beam LB1 is within a corresponding numerical range, the preliminary display panel 100p having a thickness of about 200 µm or less may be uniformly machined in the thickness direction.

A length of an area (hereinafter, the length of the first laser beam LB1) that is at least about 85% of a maximum intensity of the first laser beam LB1 may be at least about 65% of the thickness of the preliminary display panel 100p. For example, in case that the thickness of the preliminary display panel 100p is about 200 µm, the length of the first laser beam LB1 may be at least about 130 µm. In case that the length of the first laser beam LB1 is in a corresponding numerical range, the preliminary display panel 100p having a thickness of about 200 µm or less may be uniformly machined in the thickness direction.

A pulse width of the first laser beam LB1 may be in a range of about 200 fs to about 30 ps, and preferably in a range of about 300 fs to about 20 ps. In case that the pulse width of the first laser beam LB1 is within the corresponding range, the hole machining area HA may be uniformly machined while minimizing an influence of heat on the display area DA during machining of the module hole MH, thus reducing the risk of damaging the display area DA.

A spacing (shot pitch) between adjacent first beam spots LBS1 may be in a range of about 0.8 µm to about 2 µm. In case that the spacing between the first beam spots LBS1 is less than about 0.8 micrometer, heat energy may be concentrated, causing the workpiece to melt and re-deposited. In case that the spacing between the first beam spots LBS1 exceeds about 2 µm, a machining density may be low and thus cutting machining may become incomplete.

Referring to FIGS. 4 to 6, in operation 102, the second laser beam LB2 may be irradiated to the dummy area DM to completely separate the dummy area DM from the preliminary display panel 100p to form the module hole MH. The module hole MH may be a through hole formed by removing the dummy area DM.

Referring to FIG. 6, in operation 1021, the second laser beam LB2 may be irradiated to the dummy area DM for a selected period of time to apply heat to the dummy area DM. The dummy area DM may be partially separated from the effective area EA by the hole machining pattern PHA, but may be still mostly connected to the effective area EA. Upon completion of irradiation of the second laser beam LB2 in operation 1022, the dummy area DM may be shortened by compression stress generated as the dummy area DM is instantly cooled, and the dummy area DM may be separated from the effective area EA using the hole machining pattern PHA as a boundary. In operation 1023, the dummy area DM that has been shortened and separated from the effective area EA may be naturally removed from the preliminary display panel 100p by gravity.

The second laser beam LB2 may be of a different type from the first laser beam LB1. The second laser beam LB2 may be a carbon dioxide laser beam generated by a carbon dioxide (CO₂) laser device. The wavelength of the second laser beam LB2 may be in a range of about 8.0 µm to about 12.0 µm greater than the wavelength of the first laser beam LB1, and preferably in a range of about 9.0 µm to about 11.0 µm. When the wavelength of the second laser beam LB2 is within the corresponding numerical range, heat sufficient to apply compression stress to the dummy area DM may be applied without melting or cutting the dummy area DM.

The shape of the second laser beam LB2 may be a flat top Gaussian beam having a uniform intensity distribution from the center of the laser beam to opposite edges. An area from the center of the laser beam to an edge may be defined as an area where the intensity of the laser beam is approximately 30%, 40%, or 50% of the maximum intensity. The flat top Gaussian beam may be formed by additionally adding diffractive optical elements (DOE) optics to a laser device that forms a Gaussian beam.

The shape of the second laser beam LB2 may be a super-Gaussian beam. The super-Gaussian beam may be a beam that has a flatter center and steeper edges than a general Gaussian beam.

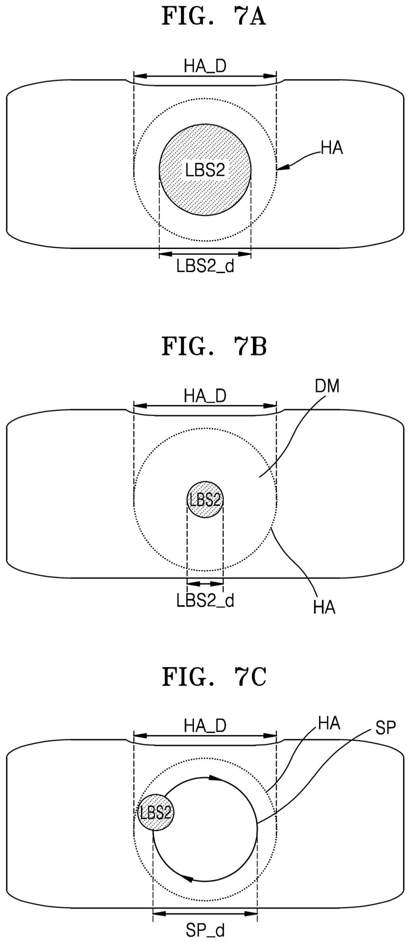

FIGS. 7A to 7C are a view for describing various examples in which the second laser beam LB2 is irradiated to the dummy area DM in operation 102. In FIGS. 7A to 7C, an operation of irradiating the second laser beam LB2 to the dummy area DM of the machining surface PS is schematically shown.

Referring to FIGS. 7A and 7B, a fixed irradiation method is shown. According to an embodiment, the second laser beam LB2 may be fixedly irradiated to a position of the dummy area DM. That is, the second laser beam LB2 may be continuously irradiated to a fixed position for a selected period of time without changing the position. In some embodiments, the second laser beam LB2 may be fixedly irradiated to the center of the dummy area DM.

In the fixed irradiation method, an irradiation time of the second laser beam LB2 may be about 100 milliseconds (ms) to 1000 ms. In case that the laser beam irradiation time is less than 100 milliseconds, sufficient heat is not applied to the dummy area DM, and in case that the laser beam irradiation time exceeds 1000 milliseconds, heat may also be transferred to the effective area EA, causing damage to the effective area EA.

In the fixed irradiation method, the size (diameter) of a second beam spot LBS2 of the second laser beam LB2 irradiated to the dummy area DM may be less than the size (diameter) of the hole machining area HA, and the size (diameter) of the second beam spot LBS2 of the second laser beam LB2 may be in a range of about 0.2 times to about 0.7 times, and preferably about 0.25 times to about 0.6 times, the size (diameter) of the hole machining area HA. In case that the size of the second beam spot LBS2 is less than the corresponding numerical range, sufficient heat may not be applied to the entire dummy area DM, making it difficult to cleanly separate the dummy area DM. In case that the size of the second beam spot LBS2 exceeds the corresponding numerical range, heat may be transferred to the effective area EA.

In FIG. 7A, an operation of irradiating the second beam spot LBS2 having a size (diameter) LBS2_d that is 0.6 times a size (diameter) HA_D of the hole machining area HA at the center of the dummy area DM in place for a selected period of time is shown. In FIG. 7B, an operation of irradiating the second beam spot LBS2 having the size (diameter) LBS2_d that is 0.25 times the size (diameter) HA_D of the hole machining area HA at the center of the dummy area DM in place for a selected period of time is shown.

Referring to FIG. 7C, unlike in the previous embodiment, a scan irradiation method is shown. According to another embodiment, the second laser beam LB2 may be irradiated while changing positions in the dummy area DM. The second laser beam LB2 may be irradiated while repeatedly moving along a scan path SP within the dummy area DM. In some embodiments, the second laser beam LB2 may move repeatedly along the scan path SP 3, 5, 7, 9 or 10 times, and the number of repetitions may be increased or decreased in various ways.

The scan irradiation method may prevent heat accumulation and evenly apply heat to the dummy area DM in comparison to the fixed irradiation method. The scan irradiation method may evenly supply heat to the wide dummy area DM regardless of the size of the beam spot.

The scan path SP may be a path along which the second laser beam LB2 moves and is irradiated, and the shape of the scan path SP may correspond to the shape of the hole machining area HA. The size (diameter) SP_d of the scan path SP may be less than the size (diameter) HA_D of the hole machining area HA, and preferably, the size (diameter) of the scan path SP may exceed 0 times, but may not be more than about 0.85 times the size (diameter) of the hole machining area HA. In case that the size (diameter) of the scan path SP is 0, i.e., the scan path SP is one point, it may correspond to the fixed irradiation method, and in case that the size (diameter) of the scan path SP exceeds 0.85 times the size (diameter) of the hole machining area HA, the effective area EA may be damaged.

In the scan irradiation method, the size (diameter) of the second beam spot LBS2 may exceed 0 and may be less than a length obtained by subtracting a radius of the scan path SP from a radius of the hole machining area HA. Thermal damage may occur in the effective area EA in case that the size of the second beam spot LBS2 is equal to or greater than a length obtained by subtracting the radius of the scan path SP from the radius of the hole machining area HA.

FIG. 7C shows an operation in which the second laser beam LB2 moves and is irradiated, repeatedly, along the scan path SP with a size (diameter) that is 0.85 times the size (diameter) of the hole machining area HA a plurality of times.

Referring back to FIGS. 4 and 5, in operation 103, the edge of the module hole MH may be machined by irradiating the third laser beam LB3 onto the edge of the module hole MH. Chamfering and/or rounding of the edge of the module hole MH may be performed using the third laser beam LB3. Chamfering may include at least one of sharp chamfering (chamfering) or curved chamfering (rounding).

The edge of the module hole MH may include an upper edge UEG where an inner surface IS of the module hole MH and the machining surface PS meet each other, and a lower edge LEG where the inner surface IS of the module hole MH and an opposite surface OPS facing the machining surface PS meet each other. The upper edge UEG and the lower edge LEG may be positioned to oppose each other, and the size (diameter) of the upper edge UEG and the size (diameter) of the lower edge LEG may be equal to each other.

The third laser beam LB3 may machine the upper edge UEG or the lower edge LEG such that at least one of the upper edge UEG or the lower edge LEG has a slope or a curvature surface. The third laser beam LB3 may machine the upper edge UEG or the lower edge LEG by cutting at least one of the upper edge UEG or the lower edge LEG such that it has a slope or a curvature surface. In some embodiments, the third laser beam LB3 may machine the upper edge UEG such that the upper edge UEG has a slope or a curvature surface extending from a first circumferential path C1 having a diameter greater than the module hole MH on the machining surface PS to a second circumferential path C2 on the inner surface IS of a machining hole. The third laser beam LB3 may machine the lower edge LEG such that the lower edge LEG has a slope or a curvature surface extending from a third circumferential path C3 having a diameter greater than the module hole MH on the opposite surface OPS to the second circumferential path C2 on the inner surface IS of the machining hole.

The third laser beam LB3 may be of a different type from the first laser beam LB1 and the second laser beam LB2. The third laser beam LB3 may be an ultraviolet (UV) laser beam generated by an UV laser device. The wavelength of the second laser beam LB2 may be in a range of about 1.0 µm to about 0.5 µm less than the wavelength of the first laser beam LB1 and the wavelength of the second laser beam LB2, and preferably in a range of about 0.2 µm to about 0.4 µm. In case that the wavelength of the third laser beam LB3 is in the corresponding numerical range, micro-machining of the module hole MH edge may be possible.

The shape of the third laser beam LB3 may be a typical Gaussian beam having an intensity that is highest at the center of the laser beam and gradually decreases toward opposite edges.

The pulse width of the third laser beam LB3 may be in a range of about 200 fs to about 30 ps, like the pulse width of the first laser beam LB1, and preferably in a range of about 300 fs to about 20 ps. In case that the pulse width of the third laser beam LB3 is in the corresponding range, the edge of the module hole MH may be uniformly machined while minimizing an influence of heat on the display area DA during machining of the module hole MH, thus reducing the risk of damaging the display area DA.

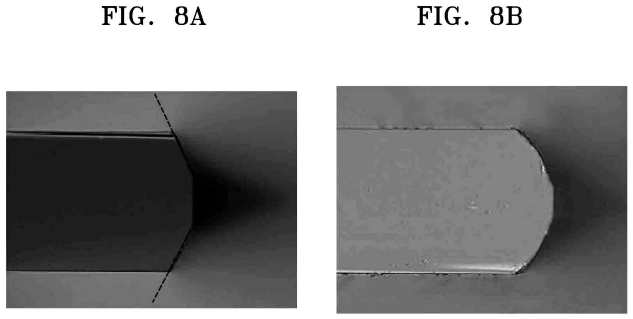

FIGS. 8A and 8B show pictures of an edge of a module hole processed in operation 103.

Referring to FIGS. 8A and 8B, the inner surface IS of the module hole MH in the cross-section in the thickness direction of the display panel 100 may have a slope or a curvature surface. The inner surface IS of the module hole MH may be machined into a chamfer shape having a plurality of slopes continuous stepwise from the machining surface PS to the opposite surface OPS, as in FIG. 8A, or into a round shape having a selected curvature from the machining surface PS to the opposite surface OPS, as in FIG. 8B.

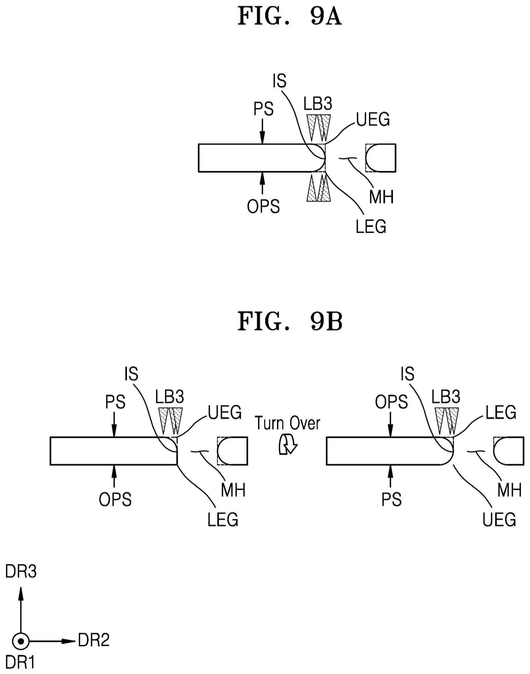

FIGS. 9A and 9B are a view for describing various examples in which an edge of the module hole MH is machined using the third laser beam LB3 in operation 103.

Referring to FIG. 9A, a double-sided machining method is shown. According to an embodiment, the third laser beam LB3 may machine the upper edge UEG and the lower edge LEG at the same time. Referring to FIG. 9B, a sequential machining method is shown. According to an embodiment, the third laser beam LB3 may machine the upper edge UEG first. After the preliminary display panel 100p is inverted such that the machining surface PS is downward in the third direction DR3 and the opposite surface OPS is upward in the third direction DR3, the third laser beam LB3 may sequentially machine the lower edge LEG. According to another embodiment, the third laser beam LB3 may sequentially machine the lower edge LEG first and then the upper edge UEG.

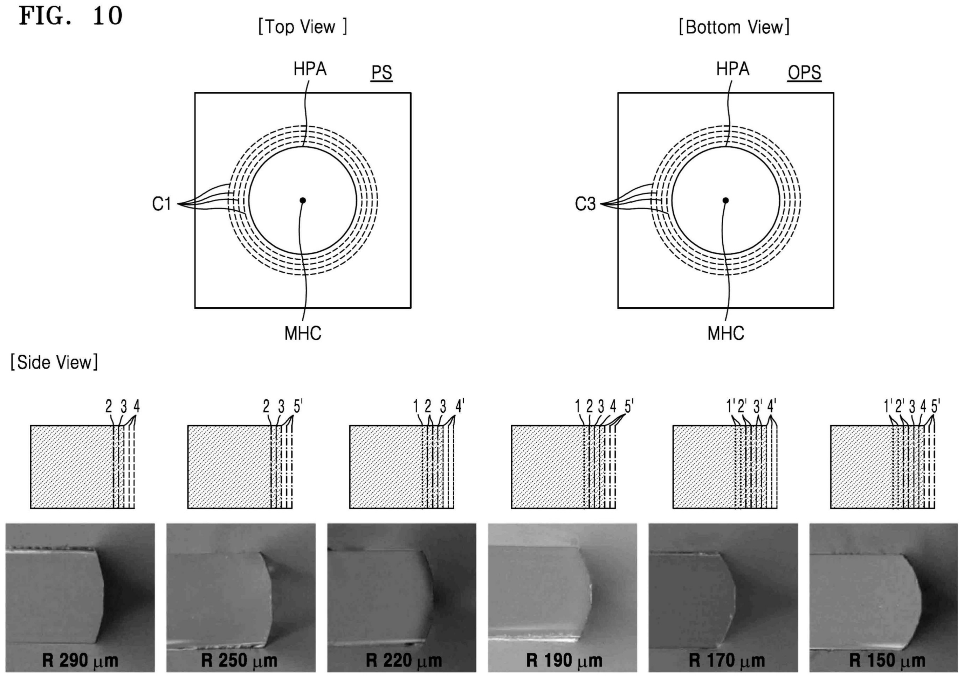

FIG. 10 is a view showing a method of machining an edge of the module hole MH using the third laser beam LB3 according to another embodiment.

Referring to FIG. 10, the third laser beam LB3 may repeatedly machine the edge of the module hole MH to adjust the shape of a slope or a curvature surface of at least one of the upper edge UEG or the lower edge LEG. The third laser beam LB3 may adjust the shape of the slope and the shape of the curvature surface by repeatedly machining the upper edge UEG and the lower edge LEG along a plurality of first circumferential paths C1 arranged on the machining surface PS and arranged in parallel with different diameters in a radial direction at the center of the module hole MH and a plurality of third circumferential paths C3 arranged on the opposite surface OPS and respectively corresponding to the plurality of first circumferential paths C1.

In the cross-sectional view of FIG. 10, each number represents an arbitrary identification number according to the positions of the first circumferential paths C1 or the third circumferential paths C3. In case that the upper edge UEG and the lower edge LEG are machined a plurality of times with the third laser beam LB3 along the first circumferential paths C1 or the third circumferential paths C3 referred to as 2, 3, and 4', the inner surface IS of the module hole MH may be machined to have a curvature surface having a curvature of 290 µm. In case that the upper edge UEG and the lower edge LEG are machined a plurality of times with the third laser beam LB3 along the first circumferential paths C1 or the third circumferential paths C3 referred to as 2, 3, and 5', the inner surface IS of the module hole MH may be machined to have a curvature surface having a curvature of 250 µm. In case that the upper edge UEG and the lower edge LEG are machined a plurality of times with the third laser beam LB3 along the first circumferential paths C1 or the third circumferential paths C3 referred to as 1, 2', 3, and 4', the inner surface IS of the module hole MH may be machined to have a curvature surface having a curvature of 220 µm. In case that the upper edge UEG and the lower edge LEG are machined a plurality of times with the third laser beam LB3 along the first circumferential paths C1 or the third circumferential paths C3 referred to as 1, 2, 3, 4, and 5', the inner surface IS of the module hole MH may be machined to have a curvature surface having a curvature of 190 µm. In case that the upper edge UEG and the lower edge LEG are machined a plurality of times with the third laser beam LB3 along the first circumferential paths C1 or the third circumferential paths C3 referred to as 1', 2', 3', and 4', the inner surface IS of the module hole MH may be machined to have a curvature surface having a curvature of 170 µm. When the upper edge UEG and the lower edge LEG are processed multiple times with the third laser beam LB3 along the first circumferential paths C1 or the third circumferential paths C3 designated as 1' 2' 3, 4, and 5', the inner surface IS of the module hole MH is processed to have a curvature surface with a curvature of 150 µm. FIG. 10 shows an example, and the shape of the slope and the shape of the curvature surface may be variously adjusted by repeatedly machining the edge of the module hole MH.

In the method of manufacturing the display device 10 according to the disclosure, the module hole MH may be formed in the display panel 100 by the dry cutting method using a laser beam without using a chemical etching method or a physical drilling method. The machining quality risk issue such as cracks occurring in the thin-film transistor layer and the encapsulation layer around the module hole MH is may be solved using a non-contact method. Through application of the dry method, end tip occurrence, chipping, and etchant penetration related to existing chemical etching may be solved. The process may be simplified and the cost may be reduced merely by using a laser beam. As an additional process for preventing penetration of the etchant into the display panel 100 is not required in the conventional chemical etching method, process simplification and cost reduction may be realized.

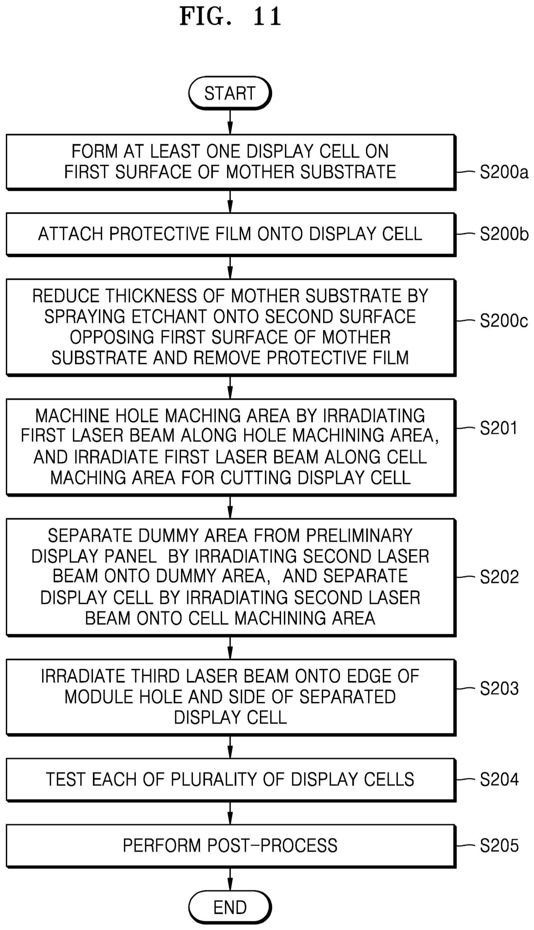

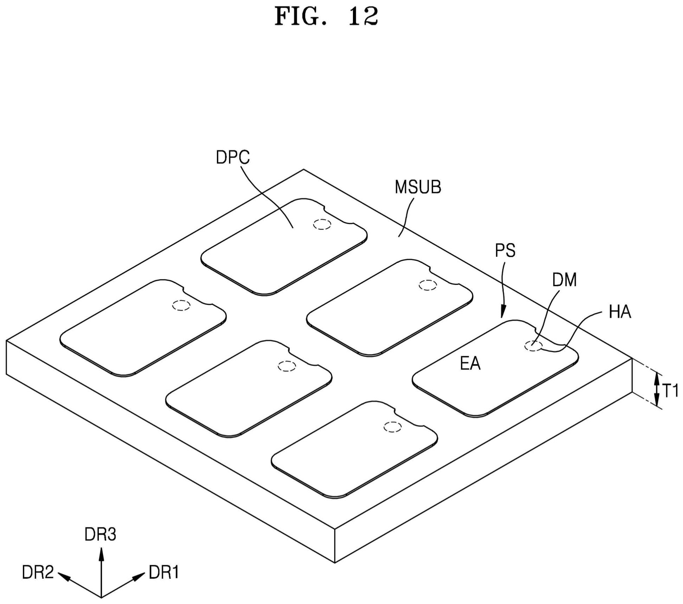

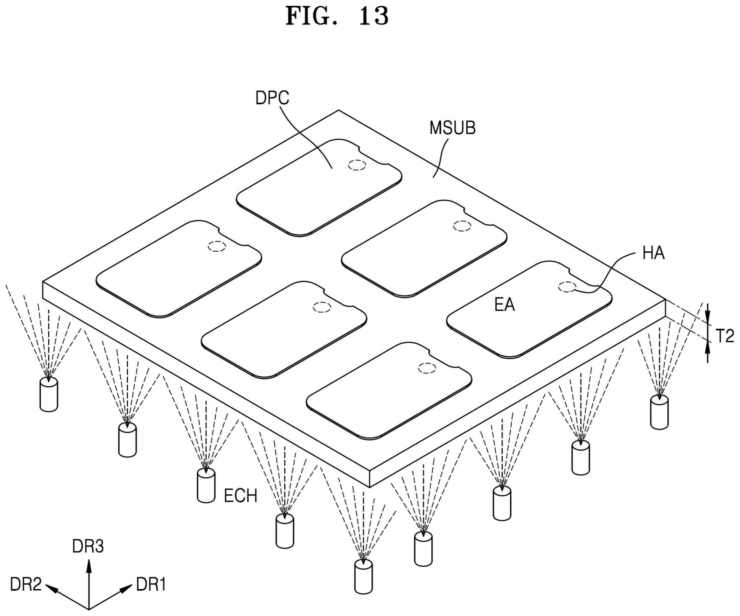

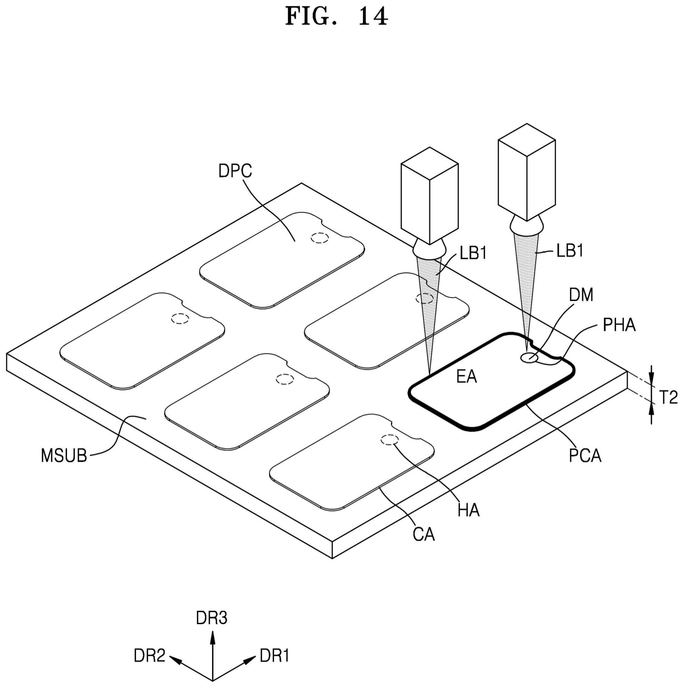

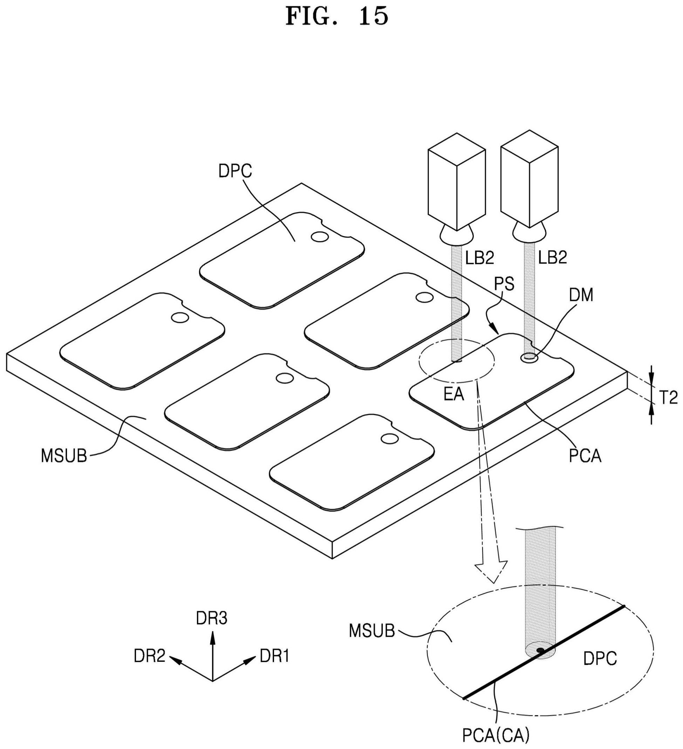

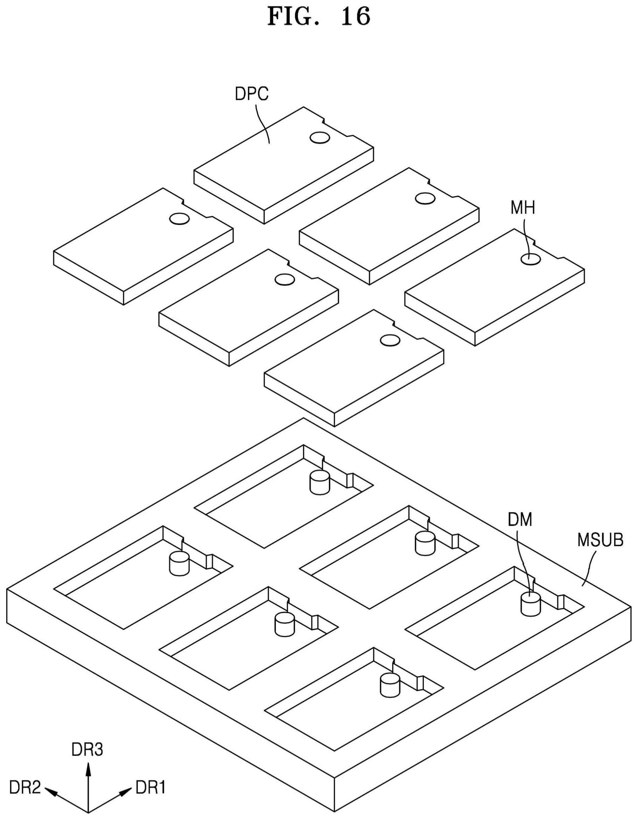

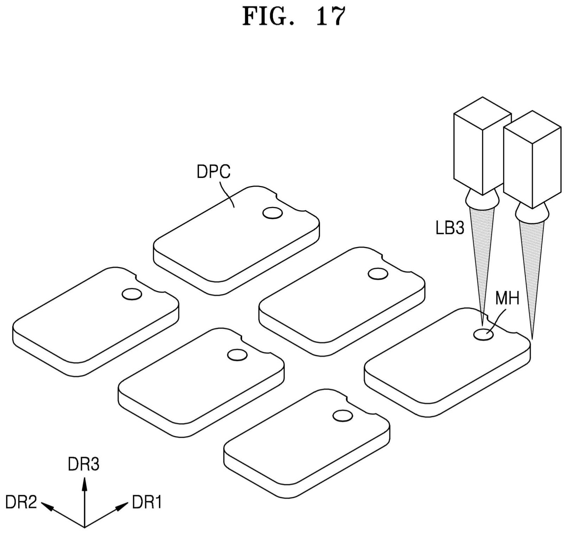

FIG. 11 is a flowchart of a method of manufacturing the display device 10 according to another embodiment. FIGS. 12 to 17 are views for explaining each operation of FIG. 11. FIG. 12 is a view for describing operations 200a and 200b of FIG. 11, FIG. 13 is a view for describing operation 200c of FIG. 11, FIG. 14 is a view for describing operation 201 of FIG. 11, FIG. 15 is a view for describing operation 202 of FIG. 11, FIG. 16 is a view for describing operation 202 of FIG. 11, and FIG. 17 is a view for describing operation 203 of FIG. 11.

FIGS. 12 to 17 are perspective views of a mother substrate MSUB and at least one display cell DPC arranged on the mother substrate MSUB.

Referring to FIG. 11, a method of manufacturing the display device 10 according to another embodiment includes an operation of forming at least one display cell DPC on a first surface of the mother substrate MSUB, an operation of attaching a protective film on the display cell DPC, an operation of spraying an etchant onto a second surface of the mother substrate MSUB facing the first surface to reduce the thickness of the mother substrate MSUB, and then detaching the protective film, a first machining operation of irradiating the first laser beam LB1 along the hole machining area HA of the display cell DPC and simultaneously irradiating the first laser beam LB1 along a cell machining area CA to cut the display cell DPC, a second machining operation of irradiating the second laser beam LB2 onto the dummy area DM of the display cell DPC to separate the dummy area DM from the display cell DPC and simultaneously irradiating the second laser beam LB2 onto the cell machining area CA to separate the display cell DPC from the mother substrate MSUB, a third machining operation of irradiating light to the edge of the module hole MH to machine the edge of the module hole MH, and at the same time, selectively irradiating the third laser beam LB3 to a side of the separated display cell DPC to machine the side of the display cell DPC, an operation of testing each of the plurality of display cells DPC, and a post-process. A manufacturing process of the display device 10 of FIG. 11 may be performed by a manufacturing system of the display device 10, and the manufacturing system of the display device 10 may include at least a first laser device (an IR laser device), a second laser device (a carbon dioxide laser device), and a third laser device (an UV laser device).

The display cell DPC may include at least the mother substrate MSUB, and the thin-film transistor layer, the display element layer, and the encapsulation layer that are sequentially stacked on the mother substrate MSUB. The display cell DPC with a reduced thickness after operation 200c may correspond to the preliminary display panel 100p of FIG. 4. The thickness of the display cell DPC after operation 200c may be about 200 µm or less, and preferably exceed about 50 µm, but may not be more than 200 µm.

The display cell DPC may include the machining surface PS on a surface thereof on which a laser beam is to be irradiated. The machining surface PS may include an effective area EA included in the display panel 100 which is a final product, the dummy area DM not included in the display panel 100 which is the final product, and the hole machining area HA corresponding to a boundary between the effective area EA and the dummy area DM. The machining surface PS of the display cell DPC may be located on the same plane as the first surface of the mother substrate MSUB.

The effective area EA, the dummy area DM, and the hole machining area HA may be the same as those described with reference to FIG. 4, and thus will refer to the foregoing description.

Referring to FIGS. 11 and 12, in operation 200a, at least one display cell DPC may be formed on a first surface of the mother substrate MSUB. The display cell DPC may include at least the mother substrate MSUB, and the thin-film transistor layer, the display element layer, and the encapsulation layer that are sequentially stacked on the mother substrate MSUB.

In operation 200b, at least one protective film (not shown) may be attached on the display cell DPC. At least one protective film may include a first protective film (not shown) and a second protective film (not shown).

A first protective film layer may be attached to cover a first surface of the mother substrate MSUB arranged between at least one display cell DPC and at least one display cell DPC. By removing a part of the first protective film layer arranged on the mother substrate MSUB, the first protective film layer may be arranged on the display cell DPC. A residual remaining after removal of the part of the first protective film layer may be the first protective film. At least one protective film may be arranged in a one-to-one correspondence to at least one display cell DPC.

The first protective film may be a buffer film for protecting the display cell DPC from external impact. The first protective film may include a transparent material.

The second protective film may be attached on the first protective film and the first surface of the mother substrate MSUB that is exposed without being covered with the first protective film. The second protective film may be an acid-resistant film to protect the display cell DPC from an etchant ECH during an etching process of the mother substrate MSUB to be performed in the next operation.

Referring to FIGS. 11 and 13, in operation 200c, a slimming process may be performed to reduce the thickness of the mother substrate MSUB by spraying the etchant ECH onto a second surface facing the first surface of the mother substrate MSUB without a separate mask. The second protective film may then be removed.

By spraying the etchant ECH onto the second surface of the mother substrate MSUB, the thickness of the mother substrate MSUB may be reduced. In some embodiments, the thickness of the mother substrate MSUB may be reduced from a first thickness T1 to a second thickness T2. In some embodiments, the second thickness T2 may be different from the first thickness T1 by approximately 50 µm or more.

After reducing the thickness of the mother substrate MSUB, the second protective film may be removed.

Referring to FIGS. 11 and 14, in operation 201, the first laser beam LB1 may be irradiated along the hole machining area HA to form the hole machining pattern PHA including cracks formed along the thickness of the display cell DPC corresponding to the hole machining area HA. As the hole machining pattern PHA corresponds to the hole machining area HA, the dummy area DM may be partially separated from the effective area EA by a crack, but may still be connected to the effective area EA. At the same time, the first laser beam LB1 may be irradiated along the cell machining area CA to cut the display cell DPC, thus forming a cell machining pattern PCA including a crack formed along the thickness of the display cell DPC corresponding to the cell machining area CA.

The cell machining area CA may be defined on the first surface of the mother substrate MSUB and may correspond to the edge of the display cell DPC. The cell machining area CA may be a part to which the first laser beam LB1 is irradiated to separate the display cell DPC from the mother substrate MSUB. The cell machining area CA may have a shape corresponding to the preliminary display panel 100p on the mother substrate MSUB.

As the cell machining pattern PCA corresponds to the cell machining area CA, the display cell DPC may be partially separated from the mother substrate MSUB by a crack, but may still be connected to the mother substrate MSUB. The cell machining pattern PCA may be a set of machining points to which the first laser beam LB1 is irradiated, corresponding to the cell machining area CA.

As the characteristics of the first laser beam LB1, such as type, shape, wavelength, length, pulse width, a spacing between beam spots, etc., are the same as those described with reference to FIG. 4, the foregoing description will be referred to.

Referring to FIGS. 11, 15, and 16, in operation 202, the second laser beam LB2 may be irradiated to the dummy area DM to completely separate the dummy area DM from the display cell DPC to form the module hole MH. At the same time, the second laser beam LB2 may be irradiated to the cell machining area CA or the cell machining pattern PCA of the display cell DPC to separate the display cell DPC from the mother substrate MSUB.

The second laser beam LB2 may be irradiated to the dummy area DM for a selected period of time to apply heat to the dummy area DM. The dummy area DM may be partially separated from the effective area EA by the hole machining pattern PHA, but may be still mostly connected to the effective area EA. The second laser beam LB2 may be irradiated to a part of the cell machining area CA or a part of the cell machining pattern PCA to apply heat to a part of the edge of the display cell DPC. In some embodiments, the second beam spot LBS2 may be positioned to overlap the cell machining area CA or the cell machining pattern PCA, and the center of the second beam spot LBS2 may lean toward the mother substrate MSUB relative to the display cell DPC. The second laser beam LB2 may be irradiated so as to lean toward the mother substrate MSUB to minimize thermal damage to the display cell DPC.

Upon completion of irradiation of the second laser beam LB2, the dummy area DM may be shortened by compression stress generated as the dummy area DM is instantly cooled, and the dummy area DM may be separated from the effective area EA using the hole machining pattern PHA as a boundary. A part of the edge of the display cell DPC may be shortened due to a compressive stress generated by instant cooling of the part of the edge of the display cell DPC, and the display cell DPC and the mother substrate MSUB may be separated from each other at the cell machining pattern PCA as a boundary.

The dummy area DM that has been shortened and separated from the effective area EA may be naturally removed from the display cell DPC by gravity. The entire display cell DPC may be naturally detached from the mother substrate MSUB by gravity due to a part of the display cell DPC being shortened and separated from the mother substrate MSUB. As the display cell DPC is larger and heavier than the dummy area DM, the display cell DPC may be easily separated from the mother substrate MSUB simply by irradiating the second laser beam LB2 to a part of the cell machining area CA or a part of the cell machining pattern PCA.

The characteristics of the second laser beam LB2, such as type, shape, wavelength, etc., may be the same as those described with reference to FIG. 4, and thus the foregoing description will be referred to.

Operations 201 and 202 may be performed by one laser system having a first laser device and a second laser device at the same time. The mother substrate MSUB may be subject to operations 201 and 202 without moving between stages.

Referring back to FIGS. 11 and 17, in operation 203, the edge of the module hole MH may be machined by irradiating the third laser beam LB3 onto the edge of the module hole MH. The third laser beam LB3 may machine the upper edge UEG or the lower edge LEG such that at least one of the upper edge UEG or the lower edge LEG has a slope or a curvature surface.

According to a selective embodiment, in operation 203, simultaneously with machining of the error of the module hole MH, the third laser beam LB3 may be irradiated to the edge of the side of the separated display cell DPC to machine the edge of the side of the separated display cell DPC. In a cross-section in the thickness direction of the display cell DPC, the edge of the side of the display cell DPC may have a slope or a curvature surface. The edge of the side of the display cell DPC may be machined into a chamfer shape having a plurality of slopes continuous stepwise from the machining surface PS to the opposite surface OPS, as in FIG. 8A, or into a round shape having a selected curvature from the machining surface PS to the opposite surface OPS, as in FIG. 8B.

Chamfering and/or rounding of the edge of the module hole MH and the edge of the side of the display cell DPC may be performed using the third laser beam LB3. Chamfering may include at least one of sharp chamfering (chamfering) or curved chamfering (rounding).

The characteristics of the third laser beam LB3, such as type, shape, wavelength, etc., may be the same as those described with reference to FIG. 4, and thus the foregoing description will be referred to.

Referring to FIG. 11, in operation 204, the machined display cell DPC may be tested using a testing device. After a probe is connected to a plurality of test pads provided in each of the plurality of display cells DPC, a lighting test may be performed for each of the plurality of display cells DPC. After end of a test, the plurality of test pads may be cut from each of the plurality of display cells DPC.

Referring to FIG. 11 below, a post-process may be performed in operation 205. The post-process may include a process of attaching the driving IC 200 and the circuit board 300 to each of the plurality of display cells DPC and removing the first protective film from each of the plurality of display cells DPC.

The driving IC 200 may be attached to the non-display area NDA located under each of the plurality of display cells DPC. The driving IC 200 may be attached onto driving pads of each of the plurality of display cells DPC using a conductive adhesive member such as an anisotropic conductive film or an anisotropic conductive adhesive.

The circuit board 300 may be attached to the non-display area NDA located at an edge under each of the plurality of display cells DPC. The circuit board 300 may be attached onto the display pads of each of the plurality of display cells DPC using a conductive adhesive member such as an anisotropic conductive film or an anisotropic conductive adhesive.

The first protective film may be removed from the display cell DPC. By attaching the cover window CW onto the display cell DPC using a transparent adhesive member, the display panel 100 may be completed.

A method of manufacturing the display device 10 according to another embodiment of the disclosure may simultaneously perform a process of machining the module hole MH of FIG. 4 and a process of separating the display cell DPC from the mother substrate MSUB and machining the side of the display cell DPC. Thus, by merging the two processes and performing them at the same time, a machining time may be shortened and equipment utilization may be optimized. In case that the two processes are performed separately, a possibility of an error occurring may be maintained because machining of the display cell DPC and machining of the module hole MH need to be aligned separately, but by performing the two processes at the same time, a machining error may be reduced and precision of laser machining may be maintained.

In the method of manufacturing the display device 10 according to embodiments of the disclosure, the first laser beam LB1 may be used in the first machining operation (sketch), the second laser beam LB2 may be used in the second machining operation (dummy removal), and the third laser beam LB3 may be used in the third machining operation (edge machining). By using different laser beams in different machining stages, precision, machining efficiency, and minimization of an influence of heat on the display panel may be achieved.

The first laser beam LB1 may be an IR laser, has a beam shape of a Bessel beam, and has a wavelength less than that of the second laser beam LB2 and greater than that of the third laser beam LB3. The first machining operation includes forming a machining pattern on a workpiece, and by using an IR laser, a penetration depth may be large and a specific area may be preliminarily weakened. By using the Bessel beam, it is possible to form a precise pattern while maintaining uniform intensity throughout the deep region. In this way, the machining pattern may be precisely formed by combining the IR laser with the Bessel beam.

The second laser beam LB2 may be a carbon dioxide laser, has a beam shape of a flat top Gaussian beam, and has a wavelength greater than that of the second laser beam LB2 and greater than that of the third laser beam LB3. The second machining operation may include removing the preliminarily cut dummy area along the machining path, and by using the carbon dioxide laser with a long wavelength, heat energy may be transferred to the dummy area without ablating it, thereby applying the compressive stress thereafter. By using the flat top Gaussian beam, uniform energy may be delivered over a wide area, allowing heat thermal energy to be delivered uniformly to the dummy area. As such, by symbiotically combining a long-wavelength carbon dioxide laser with the flat-top Gaussian beam, the dummy area may be uniformly heated while minimizing an influence of heat on the effective area, thus lowering the risk of damaging the effective area.

The third laser beam LB3 may be an UV laser, have a beam shape of a typical Gaussian beam, and have a wavelength shorter than that of the first laser beam LB1 and shorter than that of the second laser beam LB2. The third machining operation may include removing a taper of the edge of the module hole or to round the edge to prevent a crack and breakage, and by using a short-wavelength UV laser, fine machining and precise machining of the edge may be possible. By using a Gaussian beam with high intensity in the center and reduced energy in the edge, the precision of machining may be improved, and unnecessary burrs and recast layers may be provided. In this way, by combining a short-wavelength UV laser with a longitudinal Gaussian beam, final finish may be optimized by smoothing the edges while minimizing an influence of heat on the effective area, thus lowering the risk of damaging the effective area.

The display device 10 manufactured according to an embodiment may be applied to various electronic devices 1000. The electronic device according to an embodiment may include the display device 10 described above, and may further include a module or device having additional functions in addition to the display device 10.

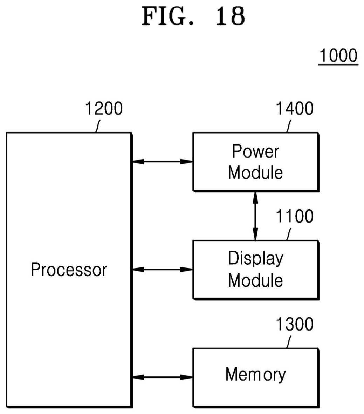

FIG. 18 is a block diagram of an electronic device 1000 according to an embodiment.

The electronic device 1000 according to an embodiment may include a display module 1100, a processor 1200, a memory 1300, and a power module 1400.

The processor 1200 may include at least one of a central processing unit (CPU), an application processor AP, a graphic processing unit (GPU), a communication processor (CP), an image signal processor (ISP), and a controller.

The controller may output various control signals necessary for driving the display module 1100. For example, the controller may apply various signals to the pixel circuit included in the thin-film transistor layer TFTL. The controller may transmit a scan control signal to the scan driver 210, and causes the scan driver 210 to output scan signals to pixel circuits in response to the scan control signal. The controller may transmit a control signal to the data driver of the driving IC 200, and the data driver may convert image data into an analog voltage (e.g., a data voltage) in response to the control signal and output the data voltage to the pixel circuits.

The memory 1300 may store data information necessary for the operation of the processor 1200 or the display module 1100. When the processor 1200 executes an application stored in the memory 1300, an image data signal and/or an input control signal may be transmitted to the display module 1100, and the display module 1100 may process the received signal and output the image information through a display screen.

The power module 1400 may include a power supply module, such as a power adapter, a battery device, etc., and a power conversion module that converts power supplied by the power supply module to generate power required for the operation of the electronic device 1000. For example, the power module 1400 may supply power to the controller, enabling the controller to operate.

At least one of the components of the electronic device 1000 may be included in the display device 10 according to the above-described embodiments. Some of individual modules functionally included in a module may be included in the display device 10 and others may be provided separately from the display device 10. For example, the display device 10 may include the display module 1100, and the processor 1200, the memory 1300, and the power module 1400 may be provided in the form of other devices in the electronic device 1000 other than the display device 10.

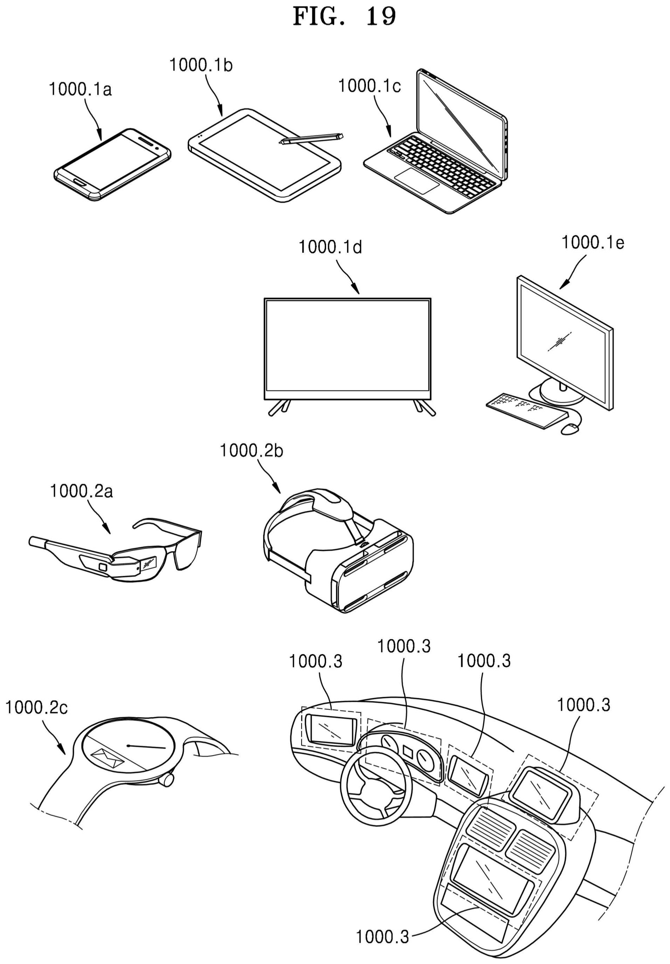

FIG. 19 show schematic diagrams of an electronic device according to various embodiments.

Referring to FIG. 19, various electronic devices to which the display device 10 according to embodiments is applied may include not only image display electronic devices such as a smart phone 1000_1a, a tablet PC 1000_1b, a laptop computer 1000_1c, a TV 1000_1d, a desk monitor 1000_1e, etc., but also wearable electronic devices including display modules such as smart glasses 1000_2a, a head mounted display 1000_2b, a smart watch 1000_2c, etc., and vehicle electronic devices 1000_3 including display modules such as an instrument panel, a center fascia, a center information display (CID) arranged on a dashboard, a room mirror display, etc., of vehicles.

The method of manufacturing a display device according to the disclosure may solve problems that occur when forming a module hole using a conventional etching process or mechanical drilling process, and may form the module hole without defects. However, the scope of the disclosure is not limited by these effects.

While some embodiments have been described, it will be readily apparent to those of skill in the art that various modifications may be made therein without departing from the scope of the disclosure. Unless otherwise stated, the description of features or aspects within each embodiment should generally be considered to be applicable to other similar features or aspects of other embodiments. Accordingly, as will be apparent to those of ordinary skill in the art, characteristics or components described in connection with a particular embodiment may be combined with characteristics or components described in connection with other embodiments. Therefore, the foregoing description should not be construed as limited to the specific embodiments disclosed herein, but should be understood to be intended for combination with or application to other embodiments. Accordingly, the true technical scope of the disclosure should be defined by the technical scope of the appended claims.

## Claims

1. A method of manufacturing a display device (10) comprising a module hole (MH) from a preliminary display panel (100p) comprising at least a substrate (SUB), and a thin-film transistor layer (TFTL), a display element layer, and an encapsulation layer which are sequentially stacked on the substrate (SUB), the method comprising:
providing the preliminary display panel (100p) comprising a machining surface (PS) on a surface thereof and having a hole machining area (HA) corresponding to the module hole (MH) defined in the machining surface (PS);
a first machining operation (S101) of irradiating a first laser beam (LB1) along the hole machining area (HA);
a second machining operation (S102) of irradiating a second laser (LB2) beam to a dummy area (DM) with the hole machining area (HA) as a boundary to separate the dummy area (DM) from the preliminary display panel (100p); and
a third machining operation (S103) of irradiating a third laser beam (LB3) onto an edge of the module hole (MH) from which the dummy area (DM) is separated, to machine the edge of the module hole.

2. The method of claim 1, wherein a type of the first laser beam (LB1) is an infrared laser beam,
a type of the second laser beam (LB2) is a carbon dioxide laser beam, and
a type of the third laser beam (LB3) is an ultraviolet laser beam.

3. The method of claim 1 or 2, wherein a shape of the first laser beam (LB1) is a Bessel beam,
a shape of the second laser (LB2) beam is a flat top Gaussian beam or super Gaussian beam having a uniform intensity distribution from a center of the second laser beam (LB2) to opposite edges of the second laser beam (LB2), and
a shape of the third laser beam (LB3) is a Gaussian beam.

4. The method of claims 1 to 3, wherein a wavelength range of the first laser beam (LB1) is less than a wavelength range of the second laser beam (LB2) and is greater than a wavelength range of the third laser beam (LB3).

5. The method of claims 1 to 4, wherein the first laser beam (LB1) is a Bessel beam, and a length of a region corresponding to 85% or more of a maximum intensity of the first laser beam (LB1) is 65% or more of a thickness of the preliminary display panel (100p).

6. The method of claims 1 to 5, wherein the second laser (LB2) beam is fixedly irradiated to a position in the dummy area (DM).

7. The method of claims 1 to 6, wherein a beam spot size of the second laser beam (LB2) is in a range of about 0.25 times to about 0.6 times the size of the hole machining area (HA).

8. The method of claims 1 to 7, wherein the second laser beam (LB2) is irradiated for a time in a range of about 100 milliseconds to about 1000 milliseconds.

9. The method of claims 1 to 8, wherein the second laser beam (LB2) is irradiated while moving a position thereof in the dummy area (DM).

10. The method of claim 9, wherein the second laser beam (LB2) is irradiated while repeatedly moving along a scan path positioned in the dummy area (DM) and/or wherein the hole machining area (HA) has a circular shape, the scan path has a circular shape, and a diameter of the scan path is 0.85 times or less a diameter of the hole machining area (HA).

11. The method of claims 1 to 10, wherein the edge of the module hole (MH) comprises an upper edge (UEG) where an inner surface of the module hole (MH) and the machining surface (PS) meet each other, and a lower edge (LEG) where the inner surface of the module hole (MH) and an opposite surface facing the machining surface (PS) meet each other, and
the third laser beam (LB3) machines at least one of the upper edge (UEG) or the lower edge (LEG) such that the at least one of the upper edge (UEG) or the lower edge (LEG) has a slope or a curvature surface.

12. The method of claim 11, wherein the third laser beam (LB3) simultaneously machines the upper edge (UEG) and the lower edge (LEG) and/or wherein the third laser beam (LB3) machines one of the upper edge (UEG) or the lower edge (LEG) first and then sequentially machines the other and/or wherein the third laser beam (LB3) repeatedly machines the edge of the module hole (MH) to adjust the shape of the slope or the shape of the curvature surface of the at least one of the upper edge (UEG) or the lower edge (LEG).

13. A method of manufacturing a display device (10) comprising a module hole, the method comprising:
forming at least one display cell (DPC) on a first surface of a mother substrate (MSUB), the at least one display cell (DPC) comprising a machining surface (PS) and having a hole machining area (HA) defined on the machining surface (PS);
reducing a thickness of the mother substrate (MSUB) by spraying an etchant onto a second surface facing the first surface of the mother substrate (MSUB);
a first machining operation (S101) of irradiating a first laser beam (LB1) onto the first surface along the hole machining area (HA) and irradiating the first laser beam (LB1) along a cell machining area (CA) for cutting the display cell (DPC);
a second machining operation (S102) of separating a dummy area (DM) from the display cell (DPC) by irradiating a second laser beam (LB2) to the dummy area (DM) on the first surface with the hole machining area (HA) as a boundary, and separating the display cell (DPC) from the mother substrate (MSUB) by irradiating the second laser beam (LB2) onto the cell machining area (CA); and
a third machining operation (S103) of irradiating the third laser beam (LB3) onto an edge of the module hole (MH) from which the dummy area (DM) is separated, to machine the edge of the module hole.

14. The method of claim 13, wherein the third machining operation (S103) further comprises machining a side edge of the separated display cell (DPC) by irradiating the third laser beam (LB3) onto the side edge of the separated display cell (DPC) and/or wherein a type of the first laser beam (LB1) is an infrared laser beam,
a type of the second laser beam (LB2) is a carbon dioxide laser beam, and
a type of the third laser beam (LB3) is an ultraviolet laser beam or wherein a shape of the first laser beam (LB1) is a Bessel beam,
a shape of the second laser beam (LB2) is a flat top Gaussian beam having a uniform intensity distribution from a center of the second laser beam (LB2) to an edge of the second laser beam (LB2), and
a shape of the third laser beam (LB3) is a Gaussian beam.

15. An electronic apparatus comprising:
a display device (10) comprising a display panel comprising at least a substrate (SUB), and a thin-film transistor layer (TFTL), a display element layer, and an encapsulation layer, which are sequentially stacked on the substrate (SUB), and a module hole (MH) provided in the display panel (100);
a controller configured to generate a control signal for driving a pixel circuit included in the thin-film transistor layer (TFTL); and
a power module (1400) configured to apply power to the controller,
wherein the display device (10) is manufactured using a method comprising:
providing a preliminary display panel (100p) comprising a machining surface (PS) on a surface thereof and having a hole machining area (HA) corresponding to the module hole (MH) defined in the machining surface (PS);
a first machining operation (S101) of irradiating a first laser beam (LB1) along the hole machining area;
a second machining operation (S102) of irradiating a second laser beam (LB2) to a dummy area (DM) with the hole machining area (HA) as a boundary to separate the dummy area (DM) from the preliminary display panel (100p); and
a third machining operation (S103) of irradiating the third laser beam (LB3) onto an edge of the module hole (MH) from which the dummy area (DM) is separated, to machine the edge of the module hole (MH).
